# EUROPEAN PATENT SPECIFICATION

(11) **EP 0 655 183 B1**
(45) Date of publication and mention of the grant of the patent: **09.07.1997**
(21) Application number: 93917736.6
(22) Date of filing: 03.08.1993
(51) Int. Cl.: H05K 3/46

(54) **METHOD OF MANUFACTURING A MULTILAYER PRINTED WIRE BOARD**
HERSTELLUNGSVERFAHREN EINER VIELSCHICHT-LEITERPLATTE
PROCEDE DE FABRICATION D'UNE CARTE IMPRIMEE MULTICOUCHES

(30) Priority: 13.08.1992 EP 92202492
(43) Date of publication of application: 31.05.1995
(73) Proprietor: AMP-Akzo LinLam VOF, NL-6824 BM Arnhem (NL)
(72) Inventor: MIDDELMAN, Erik, NL-6815 CC Arnhem (NL); ZUURING, Pieter, Hendrik, NL-6522 HH Nijmegen (NL)
(74) Representative: Kraak, Hajo
(86) International application number: EP9302069
(87) International publication number: WO9405140

(56) References cited:
- EP-A- 0 478 051
- DE-A- 4 007 558
- US-A- 3 756 891
- PATENT ABSTRACTS OF JAPAN vol. 14, no. 65 (E-884)6 February 1990 & JP,A,01 283 996 (MITSUBISHI ELECTRIC)
- RCA REVIEW vol. 29, no. 4 , December 1968 , PRINCETON US pages 582 - 599 RYAN ET AL. 'additive processing techniques for printed- circuit boards' cited in the application
- IBM TECHNICAL DISCLOSURE BULLETIN. vol. 32, no. 5B , October 1989 , NEW YORK US pages 355 - 356 'substituting fully cured dielectric for prepreg at the composite lamination level' cited in the application
- PATENT ABSTRACTS OF JAPAN vol. 14, no. 65 (E-884)6 February 1990 & JP-A-01 283 996

## Description

The invention relates to a method of manufacturing a multilayer printed wire board. Such a printed wire board comprises at least three conductive layers, of which usually at least two are copper-layers on the outer surfaces and at least one is an internal circuit. The method to which the invention pertains comprises bonding by lamination at least one hard base substrate provided with conductive traces on at least one side and at least one intermediate substrate, the bonding involving the use of an adhesive layer in between said two substrates.

A method of the above type has been disclosed in IBM Technical Disclosure Bulletin Vol 32 No. 5B, pages 355-356. In the known method use is made of at least one intermediate substrate which comprises a hard core layer provided with an adhesive layer at least at the side facing the conductive traces of the base substrate. The method serves to substantially eliminate the dimensional instability that usually occurs in composite lamination processes. While this can be recognized as a substantial improvement in the manufacture of multilayer boards, the disclosure fails to address an even more important problem associated with multilayer boards, viz. that of providing a material displaying thermal coefficients of expansion (TCE) sufficiently low so as to match the TCE of electronic components (chips) used in conjunction with the multilayer board. A woven glass fabric (cloth) being used as the reinforcement material it is immediately apparent to the person of ordinary skill in the art that the TCEs obtained are relatively high. Further, the prior art substrates and the resulting multilayer boards require improved dimension stability.

Similar considerations apply to US 3,756,891, which discloses a method of manufacturing multilayer PWBs involving the stacking of circuitized boards with adhesive coated sheets. The adhesive is chosen so as not to flow into the through-hole interconnection areas present in the boards.

A different approach towards multilayer PWBs is the sequential laminating technique disclosed in RCA review 29 (1968) pages 582-599, particularly pages 596-597. Although a base-substrate provided with circuitry on both sides is laminated with an adhesive coated dielectric layer, the adhesive coated layer is not an intermediate substrate in between base substrates in accordance with the invention, but serves as a substrate for a next printed circuit. The disclosure does not address the type of substrate used, let alone that it can provide a solution to the problem of providing multilayer boards having sufficiently low TCEs.

PWBs providing advantages with respect to TCE have been disclosed in US 4 943 334. Described is a manufacturing process which comprises winding reinforcing filaments about a square flat mandrel to form a plurality of layers of filaments intersecting at an angle of 90°, providing the plurality of layers with a curable matrix material, and curing the matrix so as to form a base material for a PWB. In order to provide multilayer PWBs the disclosure teaches a method comprising providing an assembly of PWBs in a cavity, introducing a curable matrix material into the cavity, and curing the matrix so as to form a multilayer PWB. The desired reinforcement of the matrix is obtained by the presence of fibres around the PWBs, which during the process will become embedded in the cured matrix. The method fails to provide acceptable suitable results due to, inter alia, an internal lack of thickness-tolerance.

In C.J. Coombs, jr.'s Printed Circuits Handbook, published by McGraw-Hill, chapters 31 and 32, more particularly 33 and 34, it is described, int. al., how a multiple layer printed wire board, a so-called multilayer, is generally manufactured, the process being comprised of the following steps:
- manufacturing a laminate coated on both sides with copper foil from glass fabric-epoxy prepreg;
- etching the desired pattern into the copper;
- bonding the etched laminates by pressing them together with intermediate layers of glass fibre-epoxy prepreg.

There are a number of drawbacks to this process, such as high materials costs on account of glass fabric being employed and high thermal expansion on account of the low maximum fibre content in fibre-reinforced laminates. Another major drawback to this process is that there is no absolute thickness tolerance. The thickness of a multilayer formed in this manner is dependent on, int. al., the moulding pressure exerted, the moulding temperature and the warming-up rate employed, and the "age" of the used prepreg and some other factors which are hard to control.

There are several variations from the latter process, e.g., as disclosed in EP 0 231 737 A2. In this known process a multilayer printed wire board is manufactured in a continuous process. In the embodiment according to Fig. 2 of this publication use is made of a single printed wire board (PWB) comprised of a substrate of two layers of glass cloth in a cured matrix of thermosetting synthetic material, which substrate is provided on both sides with a layer of copper traces formed by the subtractive method from the copper foil originally applied to the substrate. To this initial PWB there are applied, on both sides, two layers of glass cloth, a layer of liquid thermosetting material, such as epoxy resin, and a copper foil. After preheating the whole is laminated in a double belt press under the effect of heat and pressure. Thus, after cooling as it leaves the double belt press, a laminate is obtained which after the forming of copper traces in the outer layers makes a multilayer PWB. Hence this multilayer PWB is made up of a laminate of three substrates of glass cloth-reinforced cured epoxy resin and four layers with copper traces.

Although quite reasonable results can be obtained using the multilayer PWB manufactured according to this known process, it still has certain drawbacks. Notably, the layers of liquid, not yet cured thermosetting resin are greatly pressed together in the double belt press, as a result of which there is a substantial decrease of the laminate's thickness between the double belt press's inlet and its outlet. It has been found that as a result of this major change in thickness it is hard to maintain with sufficient accuracy the constant thickness of the finished laminate and of the finished multilayer PWB as ultimately desired. Deviations in a PWB's thickness have an unfavourable effect on its electrical properties, thus negatively affecting the quality of such a PWB. Another drawback to said known multilayer PWB is that reinforcing the substrates with fabrics is a comparatively costly affair.

DE-4 007 558 Al describes a multilayer PWB of a somewhat different type. Between a number of adjacent single PWBs (cf. Fig. 1, no. 2 of DE-4 007 558 A1) which are each composed of a substrate (cf. Fig. 1, no. 4) made up of a glass cloth impregnated with a thermosetting synthetic material and provided on both sides with copper traces (cf. Fig. 1, no. 5), there is interposed in each case a sort of intermediate substrate (Fig. 1, nos. 1-a and 1-b). The intermediate substrate (1) consists in this case of a polyimide film (1-a) of a thickness of 10 µm which is provided on both sides with an adhesive layer (1-b) of a thickness of 10 µm or less. The melting temperature of the polyimide film is higher than the temperature used during lamination, while the adhesive layers have a melting temperature below the used lamination temperature.

A disadvantage of said known multilayer PWB consists in that there is air in the voids between the copper traces (cf. Fig. 1), which may have an unfavourable effect on the properties. Other disadvantages of DE-4007 558 A1 include the high materials cost price of the described constituents and the lengthy processing time required.

In US 4 606 787 a process for manufacturing a multilayer PWB is described which comprises first (cf. Fig. 12) making a stack of a number of single PWBs with sandwiched therebetween in each case a sort of intermediate substrate of glass fibres impregnated with liquid, uncured epoxy resin. Next, said stack is pressed together under pressure and at elevated temperature, with the resin filling the voids between the conductive traces (cf. column 6, ll. 51, 52) and being cured. The pressing together of the laminate gives a substantial reduction of its thickness, making it difficult to maintain with sufficient accuracy the constant overall thickness of the finished laminate as ultimately desired and the constant thickness of the individual intermediate substrates. This has an unfavourable effect on the PWB's electrical properties, thus negatively affecting its quality.

A multilayer printed wire board in which the dielectric material is formed of UD-reinforced layers is also disclosed in JP-A-1,283,996. The disclosed multilayers are based on the direct lamination of unidirectionally oriented parallel fibres (UD) containing prepreg in a cross wise orientation.

Copending, not prepublished International patent application PCT/EP92/01133 (publication number WO 92/22192) provides a method in which said drawbacks have been obviated. The method described consists in that, use being made of a hard base substrate having conductive traces on both sides and an intermediate substrate comprising a hard core layer coated with an adhesive layer that is flowable at least at the side facing the conductive traces of the base substrate, lamination is conducted under a pressure sufficiently high so as to bring the core layer of the intermediate substrate into contact or virtually into contact with the conductive traces of the base substrate, the adhesive filling the voids that are present between the traces, the base substrate and the intermediate substrate comprising a fibre-reinforced matrix material, the reinforcement being in the form of a crosswise arrangement of layers of unidirectionally (UD) oriented fibres.

It has now been found that it may be advantageous to modify the method according to said not prepublished International patent application so as to achieve a simpler process, with even better adhesion. So, the current invention provides a method with the features of claim 1. In the method as referred to above, wherein the base substrate and the intermediate substrate comprise a fibre-reinforced thermoset matrix material, the improvement consists in that the flowable adhesive layer is coated or laminated onto the circuitized base substrate. A flowable adhesive generally is an adhesive which either is fluid or can be rendered fluid (usually by means of elevated temperature). The intermediate substrate or substrates may also be adhesive-coated, though preference is given to the use of uncoated intermediate substrates.

The intermediate substrate may also be provided with conductive traces or be rendered suitable for the formation of conductive traces (e.g. provided with copper foil or catalyzed for electroless plating) on one side. This embodiment particularly pertains to so-called masslam manufacturing. In this process use is made of one double-sided adhesive coated base substrate provided with conductive traces on both sides and two intermediate substrates, one on each side of the base-substrate, the intermediate substrates on the side facing away from the base substrate being provided with conductive traces or having a surface rendered suitable for being provided with conductive traces.

Providing the circuitized board with the flowable adhesive layer can be done in several ways, including reverse roll coating, spray coating, or other coating techniques known to the man of ordinary skill in the art. The adhesive can conceivably be applied from a hot melt, but also from solution, after which the solvent is evaporated before lamination. Water-born adhesives may also be employed. Alternatively, a solid powder adhesive can be used, to be applied, e.g., by means of dip coating or electrostatic powder coating.

Preferably, the flowable adhesive is brought to a solid, tack free state before lamination, e.g. by partial curing or by being employed at a temperature below Tg, with the proviso, of course, that the flowable adhesive can still be rendered sufficiently fluid to fill the voids between the conductive traces.

Adhesion may be promoted by subjecting the base substrates and/or the intermediate substrates to a surface treatment, e.g., by roughening or modifying the surface using pumice, sand blast, abrasive paper, corona treatment, flame treatment, chemical etching techniques, etc.

For the intermediate and base substrates there is employed a reinforced matrix material which obviates the afore-mentioned drawbacks and notably has a sufficiently low TCE and advantageous flatness. This material comprises two or more layers of reinforcing fibres or filaments embedded in a cured thermosetting synthetic material based on, e.g., epoxy resin. The reinforcement is in the form of filament-containing layers composed of a plurality of mutually parallel stretched filaments not bound in the form of a fabric and extending substantially rectilinearly, and with filaments of superposed layers crossing each other. This type of reinforced matrix material is referred to as UD-reinforced material for short. According to the invention preferably three of said filament layers not bound in the form of a fabric are arranged in the matrix material in mirror image relative to the plane of symmetry in this process, with the filaments of superposed filament layers crossing at an angle of preferably about 90°. This UD-reinforced material, more accurately referred to as a cross-ply of UD-reinforced layers, to be suitable for advantageous use in multilayer PWBs is balanced and mid-plane symmetric. An example of such a material is formed by the substrates disclosed in the afore-mentioned US 4,943,334. By virtue of the lamination method according to the invention, making use of a flowable adhesive which is not substantially present between the conductive traces of a base-substrate and the hard core of an adjacent intermediate substrate, the advantages of UD-reinforced material can be employed in a multilayer PWB.

These advantages particularly include a favourable dimension stability. Further the substrates used have relatively low TCEs in the X and Y directions, preferably about equal to those of the electrically conductive material employed (usually copper). Further, it is possible to provide substrates having coefficients of expansion in the X and Y directions about equal to the coefficient of expansion of electronic components to be used in conjunction with the multilayer PWB, more particularly silicon chips. It should be noted that these components can be applied either onto the multilayer board ("chip-on-board"), or can be embedded in a substrate such as an intermediate substrate in accordance with the present invention ("chip-in-board"). With regard to the latter embodiment an adhesive-coated substrate should be provided with open spaces for embedding the chips. Of course, it is also possible to embed the chips in spaces provided in a base-substrate. An advantageous method to manufacture a "chip-in-board" structure includes placing one or more chips on a base-substrate (and connecting it conductively with the circuitry on the base-substrate), and then laminating onto the chip-containing base-substrate an adhesive-coated intermediate substrate provided with appropriate spaces so as to surround the chip or chips attached to the base-substrate.

According to the invention, a multilayer PWB having many layers can be easily realised when each of n-1 intermediate substrates (n > 2) is sandwiched between, in each case, n adjacent base substrates, followed by lamination under increased pressure (and optionally increased temperature), under vacuum, or under a combination of the two.

A favourable embodiment of the process according to the invention is characterised in that the thickness of each intermediate substrate is 0,025-0,6 mm, although preferably the thickness of each intermediate substrate is of the same order of magnitude as that of a base substrate. The thickness of each still plastically deformable (flowable) adhesive layer on one or both sides of the circuitized base substrate is of the same order of magnitude as that of the conductive traces, which generally have a thickness of 2-70 µm. Preferably, the process according to the invention is characterised in that for the flowable adhesive layer provided on one or both sides of a circuitized base substrate's hard core layer use is made of a glue based on a still uncured or only partially cured thermosetting synthetic material, such as epoxy resin, which is cured after the voids between the conductive traces have been filled.

The core of the intermediate substrate and of the base substrate may be built up from a number of UD prepregs stacked in such a way that their reinforcing filaments cross each other, it is also possible to employ an alternative preparative process. Notably, the base substrate and the intermediate substrate can be manufactured by a continuous process, in which a laminate composed of the desired number of layers of stretched reinforcing filaments not bound in the form of a fabric is laid on a conveyor belt, with the filaments of superposed layers crossing each other. To the thus formed laminate of filament layers liquid thermosetting resin is applied, after which the laminate provided with resin is passed through a double belt press, in which, under the effect of heat and pressure, the filament layers are impregnated with resin and the resin is cured. As it leaves the double belt press the wholly or partially cured laminate can then be provided on one or on both sides with the relatively thin, non-sticking glue layer mentioned hereinbefore, whereupon said intermediate substrate is ready.

According to another conceivable process the cores of both the base substrate and the intermediate substrate are manufactured from several unidirectional laminates which preferably cross each other at an angle of 90°, are completely or virtually completely cured, and are bonded together with the aid of an adhesive layer. Laminates based on crossing UD laminates bonded together with an adhesive layer can be manufactured in static, optionally multiopening presses, as well as in autoclaves, double belt presses, and so-called vacuum bags.

To the matrix resin there may be added in a conventional manner fillers such as fine quartz powder and, say, glass powder such as boron silicate glass powder.

Although it is preferred to use a resin based on epoxy resin for the base substrate matrix, it is also possible in principle to employ other resins, such as cyanate resins, unsaturated polyester (UP) resins, vinyl ester resins, acrylate resins, BT-epoxy resin, bismaleimide resin (BMI), polyimide (PI), phenol resins, triazines, polyurethanes, biscitraconic resin (BCI). Alternatively, use may be made of combinations of the aforementioned resins, and it is also possible to blend said resins with certain appropriate thermoplastic resins, such as PPO, PES, PSU, and, int. al., PEI.

A great many polymers are suitable to be used for the described glue layer, more particularly thermosetting resins, such as epoxy resin (EP), polyurethane (PU), vinyl ester (VE), polyimide (PI), bismaleimide (BMI), biscitraconic (BCI), cyanate esters, triazines, acrylates, and blends thereof. Prior to application many additives can be added to the glue, such as catalysts, inhibitors, thixotropic agents, adhesion promotors like all kinds of silane coupling agents, and especially fillers. These fillers are preferably selected from the following group of materials: quartz powder, glass powder, ceramic powders, such as aluminium oxide powder. It is preferred that the fillers to be used should have a low thermal coefficient of expansion and a low dielectric constant. Favourable results can be attained by using hollow spheres as filler, which spheres may be of either a polymeric material or a ceramic material or glass.

For the aforementioned reinforcing filaments it is preferred to use filament yarns, although it is also possible to use non-continuous fibres. According to the invention the reinforcing yarns are preferably selected from the following group of materials: glass, such as E-glass, A-glass, C-glass, D-glass, AR-glass, R-glass, S1-glass, and S2-glass, and various ceramic materials, such as aluminium oxide en silicon carbide. Furthermore, fibres based on polymers are suitable, more particularly liquid crystalline polymers, such as paraphenylene terephthalamide (PPDT), polybenzobisoxazole (PBO), polybenzobisthiazole (PBT), and polybenzoimidazole (PBI), as well as fibres based on polyethylene terephthalate (PETP) and polyphenylene sulphide (PPS).

Within the framework of the invention various changes may be made.

By way of unlimitative Example a multilayer printed wire board is made in accordance with the invention as follows:

A 400mmx400mm base substrate is manufactured in accordance with a winding process as described in US 4,943,334. The laminate is made so as to be clad on both sides with commercially availabe double treated copper foil. Using conventional etching techniques (see C.J. Coombs, Jr.'s Printed Circuits Handbook, published by McGraw-Hill, Chapter 14), a pattern of copper traces is etched from the copper foil layers provided on this laminate, to form a double-sided printed wire board.

The double-sided printed wire board is coated with an epoxy adhesive on the basis of 36.5 parts by weight of Epikote® 5050 (brominated epoxide which is the diglycidyl ether of tetrabromo bisphenol-A having an epoxy group content of 2600 mmole/kg), 63.5 parts by weight of Epikote® 164 (solid cresol-formaldehyde novolak polyglycidyl ether epoxy resin having an epoxy group content of 4545 mmole/kg), and 3 parts by weight of a latent hardener, which is boron trifluoride complexed with monoethylamine, so as to form an adhesive coated PWB, i.e., an adhesive coated base substrate suitable for being laminated in accordance with the method of the invention.

Two other 400mm×400mm laminates are manufactured in accordance with the US 4,943,334 process of winding filaments about a mandrel. The laminate is made so as to be provided with copper foil on one side. The other side is provided with a PTFE release film (as a consequence of the process of winding about a mandrel), so as to form two intermediate substrates each having a bare surface on one side, suitable for being laminated in accordance with the method of the invention.

The above-mentioned laminates, after removal of the release film, are stacked in the following order (from top to bottom):
- Intermediate substrate, the bare surface facing down, the copper layer being atop;
- Double sided adhesive coated double sided circuitized base substrate;
- Intermediate substrate, the bare surface facing up, the copper layer facing down.

The stack is placed in a vacuum press, evacuated, and pressed while being heated to 180°C. After one hour the press is opened, and a multilayer printed wire board made in accordance with the method of the invention results.

## Claims

1. A method of manufacturing a multilayer printed wire board comprising bonding by lamination at least one hard-core base substrate which is provided with conductive traces and voids between said traces, on at least one side and at least one hard-core intermediate substrate, the bonding involving the use of an adhesive layer in between said two substrates, wherein the adhesive layer is coated onto the circuitized base substrate at the side facing the intermediate substrate, the adhesive being flowable and the lamination being conducted under a pressure bringing the intermediate substrate into contact or virtually into contact with the conductive traces of the base substrate, the adhesive filling the voids that are present between the traces, the base substrate and the intermediate substrate comprising a fibre-reinforced thermoset matrix material, the reinforcement being in the form of a crosswise arrangement of layers of unidirectionally oriented fibres.

2. A method according to claim 1, characterized in that use is made of an uncoated intermediate substrate.

3. A method according to claim 1 or 2, characterized in that an intermediate substrate is provided on both sides of the base substrate.

4. A method according to claim 3, characterized in that use is made of one double-sided adhesive coated base substrate provided with conductive traces on both sides, and that the intermediate substrates on the side facing away from the base substrate are provided with conductive traces or have a surface rendered suitable for being provided with conductive traces.

5. A method according to claim 1, characterized in that each intermediate substrate is sandwiched between adjacent base substrates each provided with a flowable adhesive layer at the side facing the intermediate substrate or substrates, and such pressure is exerted on the laminate during the laminating process as will bring said intermediate substrate or substrates into contact or virtual contact with the conductive traces of the base substrates and fill the void between these traces on either side of the intermediate substrate or substrates with the adhesive material.

6. A method according to claim 5, characterized in that each of a plurality of n intermediate substrates, with n being an integer higher than 1, is sandwiched between adjacent base substrates, the number of base substrates thus being n + 1, followed by lamination.

7. A method according to claim 5 or 6, characterized in that lamination is conducted under increased pressure and elevated temperature.

8. A method according to claim 1, characterized in that the thickness of each flowable adhesive layer is of the same order of magnitude as that of the conductive traces.

9. A method according to claim 8, characterized in that the thickness of each intermediate substrate is of the same order of magnitude as that of the base substrates.

10. A method according to any one of the preceding claims, characterized in that the base substrates are provided with electrically conductive vias.

11. A method according to any one of the preceding claims, characterized in that electrically conductive vias are formed in the substrates after each laminating step.

12. A method according to any one of the preceding claims, characterized in that for the flowable adhesive layer provided on one or both sides of a circuitized base substrate use is made of a glue based on an uncured or only partially cured thermosetting synthetic material.

13. A method according to any one of the preceding claims, characterized in that the matrix of the core layers of the substrates is selected from the following group of thermosetting synthetic materials: cyanate resins, unsaturated polyester resins, vinyl ester resins, acrylate resins, BT-epoxy resin, bismaleimide resin, polyimide, phenol resins, triazines, polyurethanes, biscitraconic resins, and combinations of these resins.

14. A method according to any one of the preceding claims, characterized in that the matrix of the core layers of the substrates also comprises a thermoplastic synthetic material.

15. A method according to any one of the preceding claims, characterized in that the matrix of the core layers of the substrates comprises thermoplastic as well as thermosetting synthetic materials.

16. A method according to any one of the preceding claims, characterized in that the reinforcing fibre is selected from the following group of materials: A-glass, AR-glass, C-glass, D-glass, E-glass, R-glass, S1-glass, S2-glass, quartz, silica, paraphenylene terephthalamide, polybenzobisoxazole, polybenzobisthiazole, and polybenzoimidazole, polyethylene terephthalate, and polyphenylene sulphide.

17. A method according to any one of the preceding claims, characterized in that the adhesive layer is comprised of a thermosetting synthetic material.

## Patentansprüche

1. Verfahren zur Herstellung einer Mehrlagenleiterplatte durch Laminierverbindung mindestens eines Hartkern-Grundsubstrates, das auf mindestens einer Seite mit leitfähigen Bahnen und Zwischenräumen zwischen den Bahnen versehen ist, mit mindestens einem Hartkern-Intermediärsubstrat, wobei das Verbinden die Verwendung einer Klebschicht zwischen den beiden Substraten umfasst und die Klebschicht auf das mit einer Schaltung versehene Grundsubstrat auf der Seite aufgebracht ist, die dem Intermediärsubstrat zugewendet ist, wobei der Klebstoff fliessfähig ist und das Laminieren unter einem Druck erfolgt, durch den das intermediäre Substrat in Kontakt oder virtuell in Kontakt mit den leitfähigen Bahnen des Basissubstrates gebracht wird, wobei der Klebstoff die zwischen den Bahnen vorliegenden Zwischenräume füllt, wobei das Basissubstrat und das Intermediärsubstrat ein faserverstärktes duroplastisches Matrixmaterial enthalten und die Verstärkung in Form einer überkreuzenden Anordnung von Lagen aus unidirektional orientierten Fasern besteht.

2. Verfahren nach Anspruch 1, dadurch gekennzeichnet, dass ein nicht beschichtetes intermediäres Substrat verwendet wird.

3. Verfahren nach Anspruch 1 oder 2, dadurch gekennzeichnet, dass ein intermediäres Substrat auf beiden Seiten des Basissubstrates vorgesehen wird.

4. Verfahren nach Anspruch 3, dadurch gekennzeichnet, dass ein doppelseitig mit Klebstoff beschichtetes Basissubstrat verwendet wird, das auf beiden Seiten mit leitfähigen Bahnen versehen ist, und dass die intermediären Substrate auf der Seite, die vom Basissubstrat abgewendet ist, mit leitfähigen Bahnen versehen sind oder eine Oberfläche aufweisen, die zum Anbringen von leitfähigen Bahnen geeignet ist.

5. Verfahren nach Anspruch 1, dadurch gekennzeichnet, dass jedes intermediäre Substrat zwischen benachbarten Basissubstraten sandwichförmig angeordnet wird, die jeweils mit einer fliessfähigen Klebstoffschicht auf der Seite versehen sind, die dem intermediären Substrat oder den intermediären Substraten zugewandt ist, und während des Laminierprozesses ein solcher Druck auf das Laminat ausgeübt wird, der das intermediäre Substrat oder die Substrate in Kontakt oder virtuellen Kontakt mit den leitfähigen Bahnen der Basissubstrate bringt und die Zwischenräume zwischen diesen Bahnen auf jeder Seite des intermediären Substrates oder der Substrate mit dem Klebstoffmaterial füllt.

6. Verfahren nach Anspruch 5, dadurch gekennzeichnet, dass jedes einer Mehrzahl von n intermediären Substraten, wobei n eine ganze Zahl grösser als 1 ist, sandwichartig zwischen benachbarten Basissubstraten angeordnet wird, wobei die Zahl der Basissubstrate demzufolge n+1 ist, und dass dann laminiert wird.

7. Verfahren nach Anspruch 5 oder 6, dadurch gekennzeichnet, dass das Laminieren unter erhöhtem Druck und erhöhter Temperatur durchgeführt wird.

8. Verfahren nach Anspruch 1, dadurch gekennzeichnet, dass die Dicke jeder fliessfähigen Klebstoffschicht von gleicher Grössenordnung ist wie diejenige der leitfähigen Bahnen.

9. Verfahren nach Anspruch 8, dadurch gekennzeichnet, dass die Dicke jedes intermediären Substrates von gleicher Grössenordnung ist wie diejenige der Basissubstrate.

10. Verfahren nach einem der vorangehenden Ansprüche, dadurch gekennzeichnet, dass die Basissubstrate mit elektrisch leitfähigen Kontaktlöchern versehen werden.

11. Verfahren nach einem der vorangehenden Ansprüche, dadurch gekennzeichnet, dass die elektrisch leitfähigen Kontaktlöcher nach jedem Laminierschritt in den Substraten gebildet werden.

12. Verfahren nach einem der vorangehenden Ansprüche, dadurch gekennzeichnet, dass für die fliessfähige Klebstoffschicht, die auf einer oder beiden Seiten eines mit einer Schaltung versehenen Basissubstrates angeordnet sind, ein Klebstoff auf Basis eines unvernetzten oder nur teilweise vernetzten duroplastischen Kunststoffmaterials verwendet wird.

13. Verfahren nach einem der vorangehenden Ansprüche, dadurch gekennzeichnet, dass die Matrix der Kernlagen der Substrate gewählt ist aus der folgenden Gruppe duroplastischer Kunststoffe: Cyanatharze, ungesättigte Polyesterharze, Vinylesterharze, Acrylatharze, BT-Epoxyharz, Bismaleimidharz, Polyimid, Phenolharze, Triazine, Polyurethane, Biscitraconsäureharze und Kombinationen dieser Harze.

14. Verfahren nach einem der vorangehenden Ansprüche, dadurch gekennzeichnet, dass die Matrix der Kernlagen der Substrate auch einen thermoplastischen Kunststoff enthält.

15. Verfahren nach einem der vorangehenden Ansprüche, dadurch gekennzeichnet, dass die Matrix der Kernlagen der Substrate sowohl thermoplastische als auch duroplastische Kunststoffe enthält.

16. Verfahren nach einem der vorangehenden Ansprüche, dadurch gekennzeichnet, dass die Verstärkungsfaser gewählt ist aus der folgenden Materialgruppe: A-Glas, AR-Glas, C-Glas, D-Glas, E-Glas, R-Glas, Sl-Glas, S2-Glas, Quarz, Siliciumdioxid, Paraphenylenterephthalamid, Polybenzobisoxazol, Polybenzobisthiazol und Polybenzoimidazol, Polyethylenterephthalat und Polyphenylensulfid.

17. Verfahren nach einem der vorangehenden Ansprüche, dadurch gekennzeichnet, dass die Klebstoffschicht auch einen duroplastischen Kunststoff enthält.

## Revendications

1. Un procédé de fabrication d'une carte de circuit imprimé multicouche comprenant l'union par stratification d'au moins un substrat de base centrale dur qui porte des pistes conductrices et de vides entre lesdites pistes sur au moins l'une des faces et au moins un substrat intermédiaire central dur, l'union comprenant l'utilisation d'une couche d'adhésif entre les deux dits substrats dans lequel la couche adhérente est appliquée sur le substrat de base portant le circuit du côté en regard du substrat intermédiaire, l'adhésif étant fluide et la stratification étant effectuée sous une pression amenant le substrat intermédiaire en contact ou pratiquement en contact avec les pistes conductrices du substrat de base. l'adhésif comblant les vides existant entre les pistes, le substrat de base et le substrat intermédiaire comprenant un matériau de matrice thermodurci renforcé de fibres, le renfort étant sous la forme d'une disposition en forme croisée de couches de fibres orientées unidirectionnellement.

2. Un procédé selon la revendication 1, caractérisé en ce que l'on utilise un substrat intermédiaire non revêtu.

3. Un procédé selon l'une quelconque des revendications 1 ou 2, caractérisé en ce qu'on dispose un substrat intermédiaire sur les deux faces du substrat de base.

4. Un procédé selon la revendication 3, caractérisé en ce que l'on utilise un substrat de base recouvert d'adhésif sur ses deux faces portant des pistes conductrices sur ses deux faces et en ce que les substrats intermédiaires de la face opposée au substrat de base portent des pistes conductrices ou présentent une surface rendue appropriée pour recevoir des pistes conductrices.

5. Un procédé selon la revendication 1, caractérisé en ce que chaque substrat intermédiaire est pris en sandwich entre des substrats de base contigus, chacun muni d'une couche d'adhésif fluide sur la face en regard du ou des substrats intermédiaire et qu'on exerce une pression telle sur le stratifié au cours de l'opération de stratification qu'on amène ledit ou lesdits substrats intermédiaires en contact ou en contact pratique avec les pistes conductrices des substrats de base et qu'on remplisse les vides, entre lesdites pistes, sur l'une et l'autre face du substrat ou des substrats intermédiaires avec la substance adhésive.

6. Un procédé selon la revendication 1, caractérisé en ce que chacune de la pluralité des n substrats intermédiaires, n étant un nombre entier supérieur à 1, est pris en sandwich entre les substrats de base adjacents, le nombre de substrats de base étant donc de n + 1, suivi d'une stratification.

7. Un procédé selon l'une quelconque des revendications 1 ou 6, caractérisé en ce que l'on effectue la stratification sous pression élevée et à haute température.

8. Un procédé selon la revendication 1, caractérisé en ce que l'épaisseur de chacune des couches de colle fluide est du même ordre de grandeur que celle des pistes conductrices.

9. Un procédé selon la revendication 8, caractérisé en ce que l'épaisseur de chacun des substrats intermédiaires est du même ordre de grandeur que celle des substrats de base.

10. Un procédé selon l'une quelconque des revendications précédentes. caractérisé en ce que les substrats de base portent des circuits de transit (vias) électriquement conducteurs.

11. Un procédé selon l'une quelconque des revendications précédentes. caractérisé en ce que les transits électriquement conducteurs sont formés dans les substrats après chaque opération de stratification.

12. Un procédé selon l'une quelconque des revendications précédentes, caractérisé en ce que pour les couches d'adhésif fluide appliquées sur l'une ou les deux faces d'un substrat de base portant un circuit. on utilise une colle à base de matière synthétique thermodurcissable non durcie ou seulement partiellement durcie.

13. Un procédé selon l'une quelconque des revendications précédentes, caractérisé en ce que la matrice des couches centrales des substrats est choisie dans le groupe suivant de matières synthétiques thermodurcissables : résines de cyanate. résines de polyester insaturées, résines d'ester vinylique, résines acryliques, résines BT-époxy, résines de bismaléimide, polyimide, résines phénoliques, triazines, polyuréthannes, résines biscitraconiques. et les combinaisons de ces résines.

14. Un procédé selon l'une quelconque des revendications précédentes. caractérisé en ce que la matrice des couches centrales des substrats comprend également une matière synthétique thermoplastique.

15. Un procédé selon l'une quelconque des revendications précédentes. caractérisé en ce que la matrice des couches centrales des substrats comprend des matières synthétiques thermoplastiques ainsi que des matières thermoplastiques thermodurcissables.

16. Un procédé selon l'une quelconque des revendications précédentes. caractérisé en ce que la fibre de renfort est choisie dans le groupe de matériaux suivants : verre-A, verre-AR, verre-C, verre-D, verre-E, verre-R, verre-S1, verre-S2, quartz, silice, paraphénylènetéréphtalamide, polybenzobisoxazole, polybenzobisthiazole et polybenzoimidazole, téréphtalate de polyéthylène et sulfure de polyphénylène.

17. Un procédé selon l'une quelconque des revendications précédentes, caractérisé en ce que la couche adhésive comprend une matière synthétique thermodurcissable.
